# FASCICULE DE BREVET EUROPEEN

(11) **EP 0 928 062 B1**
(45) Date de publication et mention de la délivrance du brevet: **02.11.2005**
(21) Numéro de dépôt: 98403337.3
(22) Date de dépôt: 30.12.1998
(51) Int. Cl.: H03F 1/32

(54) **Procédé de correction de linéarité et correcteur de linéarité pour amplificateur de puissance et amplificateur equipé d'un tel correcteur**
Verfahren und Schaltung zur Korrektur der Linearität für Leistungsverstärker und Verstärker mit einer solchen Schaltung
Linearity correction method and circuit for power amplifier and amplifier with such a circuit

(30) Priorité: 30.12.1997 FR 9716679
(43) Date de publication de la demande: 07.07.1999
(73) Titulaire: Thales, 75008 Paris (FR)
(72) Inventeur: Berranger, Robert, 94117 Arcueil Cedex (FR)
(74) Mandataire: Chaverneff, Vladimir

(56) Documents cités:
- EP-A- 0 608 697
- EP-A- 0 731 556

## Description

La présente invention concerne la correction de linéarité des amplificateurs de puissance et, en particulier, des amplificateurs de puissance utilisés en radiofréquences.

Il est important, pour l'amplification d'un signal modulé à amplitude variable, d'utiliser un amplificateur linéaire.

Il est connu de rendre un amplificateur linéaire grâce à une boucle de contre-réaction, feed back loop dans la littérature anglo-saxonne, qui compare l'amplitude du signal d'entrée à celle du signal de sortie atténué pour fournir un signal de correction ; ce signal est ajouté au signal d'entrée afin de compenser les défauts de linéarité. Cette correction n'est pas applicable aux amplificateurs de puissance à large bande utilisés en radiofréquences car, du fait des nombreux éléments réactifs qu'ils comportent et des longueurs de ligne non négligeables par rapport à la longueur d'onde du signal à amplifier, l'amplificateur corrigé devient rapidement instable.

Il est connu d'effectuer une correction de linéarité à l'aide de deux boucles de contre-réaction, l'une d'amplitude en fonction de l'enveloppe du signal et l'autre de phase, cette boucle de phase ne passant pas le continu afin d'être indépendante du déphasage constant. La mise en oeuvre est complexe et donc très coûteuse et les seules réalisations industrielles concernent des amplificateurs à bande étroite.

Il est connu d'effectuer une correction sur le signal amplifié en lui ajoutant, dans un additionneur de sortie, un signal produit par un amplificateur auxiliaire, en fonction de la distorsion constatée sur le signal amplifié comparé au signal à amplifier. Les réalisations industrielles ne concernent que des amplificateurs de faible puissance et à bande étroite en raison d'un très mauvais rendement et de problèmes de désadaptation en sortie de l'additionneur.

Il est également connu de chercher à corriger les défauts de linéarité d'un amplificateur en effectuant une pré-distorsion au moyen de tables de réglage préétablies, adressées soit par le signal de sortie démodulé pour effectuer une pré-distorsion du signal de modulation, soit par le signal d'entrée modulé pour effectuer une modulation parasite du signal d'entrée modulé; dans le premier cas la qualité du résultat est liée à la qualité de la chaîne de démodulation et cette dernière est insuffisante, dans l'état actuel de la technique, pour atteindre les performances demandées aux amplificateurs de puissance utilisés en radiofréquences; dans le second cas la correction n'est pas adaptative, la mise en oeuvre est complexe et coûteuse.

Il est également connu de EP 0 731 556 d'effectuer une pré-distorsion adaptive du signal modulé à l'aide de tables adressées en fonction du signal modulant et reactualisées à partir d'une comparaison entre les signaux de modulation avant la pré-distorsion et après l'amplification.

Le but de la présente invention est d'éviter ou, au moins de réduire les inconvénients des correcteurs dont il a été question ci-avant. Ceci est obtenu en effectuant une pré-distorsion adaptative du signal modulé à l'aide de tables adressées en fonction du signal modulant et réactualisées à partir d'une comparaison entre les signaux de modulation avant la pré-distorsion et après amplification, qui sont transposées en bande de base avant la dite comparaison.

Selon l'invention il est proposé un procédé de correction de linéarité pour amplificateur de puissance, dans lequel une pré-distorsion est effectuée, sur un signal modulé à amplifier, à partir de coefficients mémorisés, ce procédé consistant à commander la fourniture des coefficients en fonction de la modulation du signal à amplifier, à transposer en bande de base les signaux à amplifier et amplifié et à modifier éventuellement les coefficients mémorisés en fonction d'une comparaison entre les deux signaux issus de la transposition, caractérisé en ce que le signal à amplifier et les signaux transposés en bande de base sont, chacun, partagés en deux composantes orthogonales I et Q, en ce que la pré-distorsion est effectuée séparément sur chacune des composantes orthogonales I et Q du signal à amplifier, à partir des rapports d'une part des composantes I des signaux transposés provenant du signal à amplifier et du signal amplifié et d'autre part des composantes Q de ces mêmes signaux transposés et en ce que les deux composantes obtenues après pré-distorsion sont combinées pour constituer le signal d'entrée de l'amplificateur.

Selon l'invention il est proposé un correcteur de linéarité pour amplificateur de puissance, comportant un circuit de modulation pour recevoir un signal modulé à amplifier et le pré-distordre avant amplification par l'amplificateur de puissance et un circuit de mémoire pour commander la modulation effectuée par le circuit de modulation, caractérisé en ce qu'il comporte un circuit de détection pour, en fonction de la modulation du signal à amplifier, fournir une adresse du circuit de mémoire, un premier et un second transposeur en bande de base pour recevoir respectivement les signaux à amplifier et amplifié, et un processeur pour recevoir l'adresse et pour comparer les signaux fournis par les transposeurs afin de calculer des modifications à apporter éventuellement au contenu du circuit de mémoire.

La présente invention sera mieux comprise et d'autres caractéristiques apparaîtront à l'aide de la description ci-après et des figures s'y rapportant qui représentent :
- la figure 1, un schéma simplifié d'un correcteur de linéarité associé à un amplificateur de puissance,
- la figure 2, un schéma correspondant à celui de la figure 1 mais plus détaillé,
- la figure 3, une variante de réalisation pour une partie du schéma selon la figure 2.

Dans les différents schémas les dispositifs de synchronisation précise, relevant de la technologie courante, n'ont pas été représentés en vue de rendre les dessins plus clairs et de simplifier l'exposé.

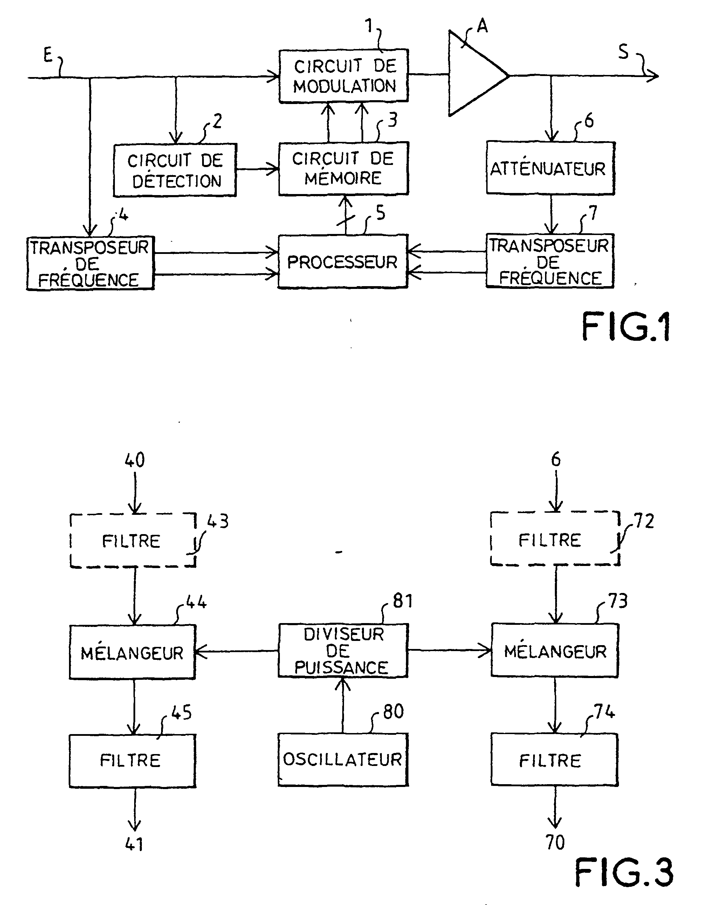

La figure 1 représente un amplificateur RF de puissance, A, équipé d'un correcteur de linéarité, 1 à 7. Le montage selon la figure 1 est destiné à amplifier linéairement un signal d'entrée analogique, E, constitué par une porteuse HF modulée par un signal d'information; le montage fournit un signal de sortie noté S sur la figure.

Le signal E est appliqué à l'entrée du signal de porteuse d'un circuit de modulation 1, à l'entrée d'un circuit de détection 2 et à l'entrée d'un transposeur de fréquence 4.

Un circuit de mémoire 3, dont le contenu est adressé par le signal de sortie du circuit de détection 2, fournit au circuit 1, sur deux voies en quadrature I, Q, une modulation pour le signal E.

Le signal de sortie S est appliqué, via un atténuateur 6, à l'entrée d'un transposeur de fréquence 7.

Les sorties, en quadrature, I et Q, des transposeurs de fréquence 4 et 7 sont reliées à un processeur 5 qui commande le contenu du circuit de mémoire 3.

Le montage selon la figure 1 comporte deux parties imbriquées qui peuvent fonctionner simultanément :
- une première partie avec le circuit de modulation 1 qui effectue une modulation du signal HF modulé, E, après l'avoir décomposé en deux voies en quadrature. La modulation s'effectue séparément sur chacune des voies en quadrature au moyen respectivement de deux coefficients fournis par le circuit de mémoire 3. Le circuit de mémoire est adressé par la valeur du module du signal E telle qu'elle est donnée par le circuit de détection 2. Ce circuit de mémoire constitue donc une table à une dimension mais il est également possible d'employer une table à deux dimensions dont le contenu ne serait plus adressé par le module du signal E mais par les deux composantes I et Q du vecteur représentatif de la modulation du signal E. La première partie fonctionne en permanence dès qu'un signal E est à amplifier.
- une seconde partie avec les deux transposeurs 4 et 7 qui transposent en bande de base respectivement le signal E et le signal S, ce dernier après atténuation dans l'atténuateur 6. Ces transposeurs sont strictement identiques et ils fournissent chacun le résultat de leur transposition sous la forme de deux signaux numériques en quadrature I et Q. La seconde partie comporte le processeur 5 qui compare les signaux I et Q fournis par le transpondeur 4 aux signaux I et Q fournis par le transposeur 7 afin de déterminer, en tenant compte de la fonction de transfert du circuit de modulation 1, la valeur des coefficients contenus dans le circuit de mémoire 3.

La correction de linéarité effectuée par modulation à l'aide des coefficients fournis par le circuit de mémoire 3, serait bonne dès la mise en fonctionnement du montage si la fonction de transfert du circuit de modulation 1 était parfaitement connue, ce qui n'est pas le cas, mais le fait que les deux parties peuvent travailler simultanément permet d'effectuer plusieurs itérations. Un excellent résultat peut ainsi être obtenu sans avoir besoin de tolérances sévères sur les composants du circuit de modulation ; avec une tolérance globale de 10%, facile à obtenir, la troisième itération apporte déjà une précision de (0,1)³=10⁻³ sur la correction de linéarité, ce qui est amplement suffisant.

Il apparaît que, pour les amplificateurs de puissance, la distorsion en amplitude et phase est principalement fonction de l'amplitude du signal à leur entrée. C'était le cas pour tous les amplificateurs qui ont été étudiés et corrigés en linéarité lors de la mise en oeuvre de montages selon la figure 1 ; ceci a permis d'utiliser dans le circuit de mémoire 3 une mémoire 30 à une seule entrée d'adressage, cet adressage se faisant en fonction de l'amplitude du signal E.

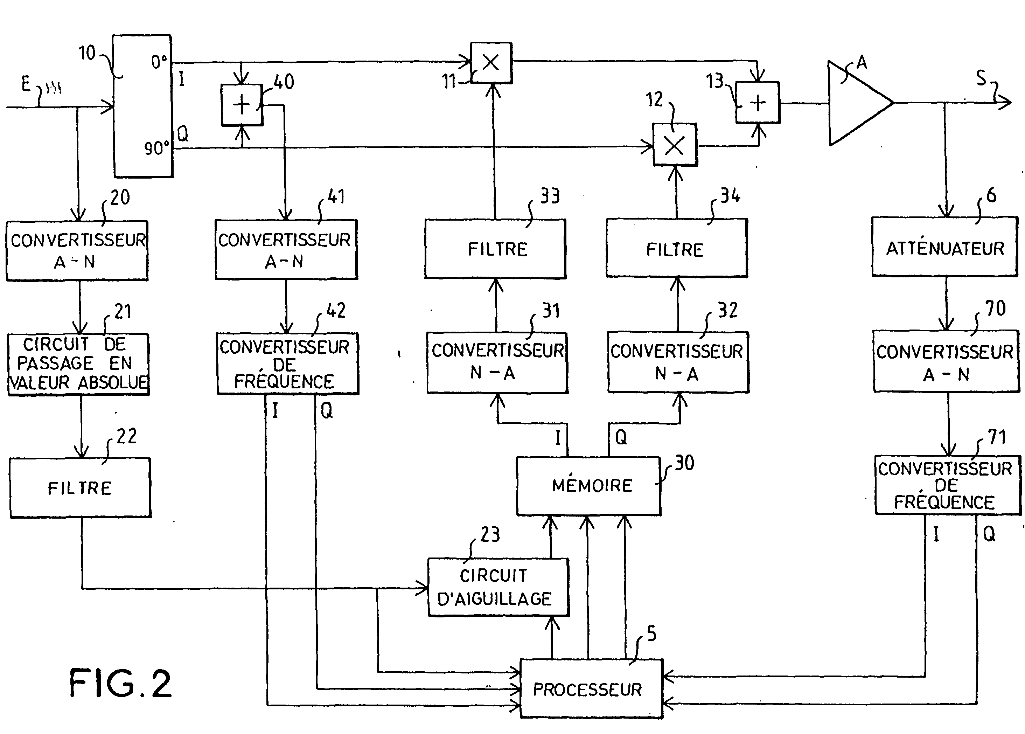

La figure 2 est une vue plus détaillée du montage selon la figure 1.

Un déphaseur différentiel à 90°, 20, reçoit le signal E et délivre sur ses deux sorties des signaux I et Q à égalité de puissance mais en quadrature de phase ; ces signaux sont appliqués respectivement aux premières entrées de deux multiplieurs analogiques 11, 12 et les sorties des multiplieurs sont respectivement reliées aux entrées d'un additionneur linéaire, 13, de type combineur deux voies dont la sortie est connectée à l'entrée d'un amplificateur A. Les circuits 10 à 13 correspondent au circuit de modulation 1 de la figure 1 tandis que l'amplificateur A constitue l'amplificateur de puissance portant la même référence sur la figure 1. Dans la réalisation qui a servi d'exemple à la présente description les multiplieurs 11, 12 sont des multiplieurs de type AD 834 de ANALOG DEVICES.
Un convertisseur analogique-numérique 20 reçoit le signal E. Ce convertisseur, de type AD 9042 de ANALOG DEVICES, a sa sortie reliée à l'entrée d'un circuit de passage en valeur absolue 21 ; le circuit 21 effectue un OU exclusif. Le convertisseur ayant un format de sortie des données de type "complément à 2", il suffit d'effectuer un OU exclusif entre le bit de signe et les autres bits pour obtenir la valeur absolue. Un filtre passe-bas, réalisé sous forme numérique câblé, 22, aussi appelé FIR d'après le sigle de son appellation anglo-saxonne, finite impulse responce, reçoit le signal de sortie du circuit 21 ; ce filtre, de type HSP 43168 de HARRIS, fournit sur sa sortie un signal numérique filtré, représentatif de la valeur de l'amplitude à l'instant t de l'enveloppe du signal E ; ce signal numérique est appliqué à une entrée d'un processeur 5 et, à travers un circuit d'aiguillage 23, commandé par le processeur 5, à l'entrée d'adressage d'une mémoire numérique 30 qui comporte deux cases distinctes à chacune de ses adresses. Les circuits 20 à 23 correspondent au circuit de détection 2 de la figure 1 tandis que le processeur 5 constitue le processeur portant la même référence sur la figure 1.

Le signal d'entrée est reconstitué par addition des signaux de sortie du déphaseur dans un amplificateur 40 de type MAX 4108 de MAXIM. Cette solution est adoptée pour laisser, hors de la boucle, l'erreur de phase absolue en fonction de la fréquence du déphaseur 10 et ne conserver que son déphasage différentiel qui, lui, reste constant.

Un convertisseur analogique-numérique, 41, de type AD 9042 de ANALOG DEVICES, a son entrée reliée à la sortie de l'additionneur 40 et sa sortie reliée à l'entrée d'un convertisseur de fréquence 42 de type HSP 50016 de HARRIS ; ce convertisseur 42 est un convertisseur en bande de base I et Q dont les deux voies de sorties sont connectées aux processeur 5.

Une partie du signal S de sortie de l'amplificateur A est appliqué, via un atténuateur ,6, constitué par une sonde, à l'entrée d'un convertisseur analogique-numérique 70 dont la sortie est reliée à l'entrée d'un convertisseur de fréquence 71. Les circuits 70, 71 sont respectivement identiques aux circuits 41, 42 et les deux voies de sortie du convertisseur 71 sont connectées au processeur 5.

La mémoire 30 dont le contenu est fourni par le processeur 5 et dont l'adressage est fait par le circuit 23, fournit sur deux voies, I et Q, des coefficients de correction pour effectuer une pré-distorsion du signal à amplifier. Ces voies sont respectivement reliées aux entrées de deux convertisseurs numériques-analogiques 31, 32, de type AD 7945 de ANALOG DEVICES. Les sorties des convertisseurs 31, 32 sont respectivement reliées aux entrées de deux filtres analogiques passe-bas 33, 34 et les sorties de ces filtres sont respectivement reliées aux secondes entrées des multiplieurs 11, 12.

Les deux convertisseurs analogiques-numériques 41, 70 et les deux convertisseurs de fréquence 42, 71 fonctionnent avec le même synchronisme et, de plus, les deux convertisseurs de fréquence ont exactement la même configuration. Les temps de transit des signaux dans les circuits 41, 42 et dans les circuits 70, 71 sont donc égaux. De plus il est à noter que les convertisseurs de fréquence conservent l'information de phase, c'est-à-dire qu'une rotation de phase de n degrés à l'entrée est de n degrés à la sortie, quelle que soit la fréquence, et qu'ils conservent l'information d'amplitude. Ainsi les sorties des convertisseurs sont les répliques fidèles de leurs entrées.

La détermination des coefficients de correction à introduire dans la mémoire 30 peut être effectuée de différentes manières ; ci-après il est indiqué comment elle est effectuée dans l'exemple de réalisation qui a servi à la présente description.

Les données dont dispose le processeur 5 se présentent sous la forme de valeurs numériques obtenues à partir des échantillonnages effectués dans les convertisseurs analogiques-numériques 20, 41, 70 ; il s'agit de l'amplitude du signal d'entrée, du I et du Q d'entrée, du I et du Q de sortie.

Au départ les coefficients introduits dans la mémoire 30 sont, partout, des coefficients unitaires ; le facteur multiplicatif appliqué sur la seconde entrée des multiplicateurs 11 et 12 est alors de 1 et le signal d'entrée ne subit donc aucune correction.

L'acquisition est effectuée pour contenir deux explorations complètes de l'échelle d'amplitude, l'une montante et l'autre descendante ; ceci est obtenu par modulation du signal d'entrée par une dent de scie symétrique. Cinq acquisitions simultanées sont ainsi réalisées : sur les signaux I et Q des convertisseurs 42 et 71 et sur le signal d'amplitude fourni par le filtre 22. Ensuite est effectuée une normalisation en amplitude crête et en phase moyenne des signaux de sortie avec les signaux d'entrée ; cette normalisation sera précisée plus loin.

Les échantillons dont le module est inférieur à un seuil donné sont éliminés afin d'éviter une imprécision dans les calculs. Pour simplifier et réduire les calculs à effectuer, seules sont retenues les paires d'échantillons I, Q de même signe. De plus, toujours pour avoir une bonne précision, seules sont pris en compte les paires d'échantillons I, Q dont le rapport est compris entre 0,5 et 2.

Pour tous les échantillons conservés le, Qe fournis par le convertisseur 42 et pour tous les échantillons Is, Qs correspondants fournis par le convertisseur 71, les couples de rapport le/ls et Qe/Qs sont calculés et stockés à la même adresse mais dans des cases distinctes d'une table provisoire de la mémoire interne du processeur 5 ; l'adresse de stockage est donnée par l'échantillon d'amplitude c'est-à-dire par le signal de sortie du filtre 22 ; l'adresse comporte deux cases distinctes, l'une pour Ie/Is, l'autre pour Qe/Qs. Du fait que, d'une part, le nombre d'échantillons est bien plus important que le nombre d'adresses, et que, d'autre part, certains échantillons sont éliminés, chaque adresse peut hériter d'un nombre de calculs compris entre zéro et "nombre d'échantillons/nombre d'adresses".

A la fin de l'opération d'acquisition la table provisoire contient, à certaines adresses, la somme de un à "nombre d'échantillons/nombre d'adresses" couples de rapports Ie/Is et Qe/Qs ; il en est fait la moyenne. D'autres adresses ne contiennent aucune valeur; des valeurs calculées par interpolations linéaires y sont introduites. Quant aux deux extrémités de la table, les valeurs à y introduire sont calculées par extrapolation.

Avant d'effectuer les calculs destinés à remplir toutes les cases de la table provisoire il est procédé à une normalisation en amplitude et en phase moyenne des signaux le, Qe et Is, Qs.

La normalisation en amplitude consiste simplement à calculer les modules maximum, c'est-à-dire la racine carrée de I² + Q², pour les le, Qe et les Is, Qs, à en faire le rapport et à multiplier tous les Is, Qs par ce rapport.

Pour simplifier la mise en oeuvre et, surtout, éviter des erreurs de raccordement et une diminution de la dynamique, le circuit de modulation 1 n'est utilisé que dans un seul quadrant. L'erreur de phase dynamique de l'amplificateur, A, ne dépassant guère ± 15°, un seul quadrant est largement suffisant puisqu'il permet théoriquement de rattraper ± 45°. La contrepartie est qu'il faut recaler le signal de sortie en phase moyenne avec le signal d'entrée. La solution retenue dans l'exemple décrit a été de numéroter les échantillons changeant de signe dans les signaux le, et Is, d'en déterminer l'écart moyen en nombre de coups d'horloge puis de décaler tous les signaux Is, Qs de la valeur de cet écart pour les faire coïncider avec le, Qe.

Les coefficients de correction obtenus par normalisation et calcul, et stockés en table provisoire dans la mémoire interne du processeur 5, sont multipliés par la fonction de transfert du circuit de modulation 1. Les résultats obtenus sont transférés dans la mémoire 30, où il peut être prévu une opération de lissage par calcul d'une moyenne glissante dans une fenêtre de largeur réglable; cette opération classique réalise un filtrage passe-bas du premier ordre qui a la propriété d'avoir une fréquence de coupure proportionnelle à la fréquence du signal d'adressage c'est-à-dire de l'enveloppe.

L'opération de calcul des coefficients de correction peut ensuite être reprise, mais cette fois non plus en partant de coefficients unitaires dans la mémoire 30 mais des coefficients déjà contenus dans cette mémoire et les nouveaux coefficients sont obtenus par multiplication des anciens par les valeurs correspondantes dans la table provisoire.

La variation du gain de la chaîne d'amplification étant une fonction très lente dans le temps, ne requiert pas de ressources importantes du processeur 5 pour effectuer un "rafraîchissement" des coefficients de correction à l'aide du signal amplifié lors d'un fonctionnement normal, c'est-à-dire à l'aide d'un signal quelconque et non pas d'un signal spécifique tel qu'il est choisi pour l'acquisition dont il a été question ci-avant.

Dans l'exemple décrit le rafraîchissement s'effectue de la manière suivante :
- une acquisition est effectuée en fonctionnement normal, donc à l'aide d'un signal quelconque,
- il est calculé une transformée de Fourier rapide de l'enveloppe sur un nombre de points suffisant pour avoir une bonne résolution, soit 4 000 points environ. Si la transformée de Fourier rapide présente une raie principale nettement détachée en amplitude et de fréquence relativement basse (<20Hz), le groupe d'échantillons est déclaré valable pour une comparaison entrée/sortie
- un calcul de coefficients est effectué après normalisation avec les valeurs en mémoire
- si le nombre de points calculés dépasse une certaine densité les tables de correction sont remises à jour.

Il est à noter toutefois que cette façon n'est pas applicable avec un signal E présentant une modulation numérique à spectre continu. Dans ce cas le rafraîchissement ne peut se faire qu'en ajoutant un roulement, patern dans la littérature anglo-saxonne, spécial qui crée les conditions spectrales requises pour effectuer à la fois la synchronisation bit et le calcul de correction.

La présente invention n'est pas limitée à l'exemple décrit. C'est ainsi que la détermination du module du signal d'entrée E, effectuée par les circuits 20, 21, 22 selon la figure 2, peut être effectuée avec un détecteur analogique suivi d'un filtre passe-bas et d'un convertisseur analogique-numérique.

La détermination du module d'entrée peut même être faite par calcul de la racine carrée de I² + Q², où I et Q sont les signaux des deux voies de sortie du convertisseur 42; dans ce cas les circuits 20 à 23 n'existent plus mais il y a nécessité d'un traitement rapide par l'organe de calcul et d'un faible retard dans le convertisseur 42.

Les conversions de fréquence effectuées par les convertisseurs 42 et 70 peuvent, elles aussi, être obtenues par calcul en utilisant une mémoire pour le programme de calcul et le stockage des données.

Pour des fréquences supérieures à la gamme HF et compte tenu des performances des composants actuellement disponibles, il est nécessaire de réduire les fréquences de travail par mélange avant de procéder aux deux conversions de fréquence. La figure 3 montre une possibilité de réaliser la transposition dans ces conditions. Dans le schéma selon la figure 2 les circuits de la figure 3 sont à insérer entre les circuits 40, 41 d'une part et 6, 70 d'autre part.

La sortie de l'additionneur 40 est couplée, éventuellement par un filtre 43, à l'entrée RF d'un mélangeur 44 dont la sortie FI est couplée par un filtre passe-bas 45 à l'entrée du convertisseur analogique-numérique 41. De la même façon et avec des composants identiques, la sortie de l'atténuateur 6 est couplée, éventuellement par un filtre 72, à l'entrée RF d'un mélangeur 73 dont la sortie FI est couplée par un filtre passe-bas 74 à l'entrée du convertisseur analogique-numérique 70. A toutes fins utiles il est rappelé que les sigles RF, FI et OL utilisés dans ce document signifient respectivement radiofréquence, fréquence intermédiaire et oscillateur local.

Un oscillateur à fréquence fixe 80, piloté par la même fréquence d'horloge que tout le reste du montage, délivre un signal qui est appliqué, via un diviseur de puissance 81, aux entrées OL des mélangeurs 44 et 73.

La nécessité de mettre les filtres 43, 72 dépend du rapport entre d'une part la bande de fréquence couverte à l'entrée de l'échantillonneur du convertisseur analogique-numérique et d'autre part celle couverte par l'amplificateur à linéariser; c'est ce que l'on appelle le filtrage des repliements de spectres.

## Revendications

1. Procédé de correction de linéarité pour amplificateur de puissance, dans lequel une pré-distorsion est effectuée, sur un signal modulé à amplifier (E), à partir de coefficients mémorisés, ce procédé consistant à commander la fourniture des coefficients en fonction de la modulation du signal à amplifier, à transposer en bande de base les signaux à amplifier (E) et amplifié (S) et à modifier éventuellement les coefficients mémorisés en fonction d'une comparaison entre les deux signaux issus de la transposition, **caractérisé en ce que** le signal à amplifier et les signaux transposés en bande de base sont, chacun, partagés en deux composantes orthogonales I et Q, **en ce que** la pré-distorsion est effectuée séparément sur chacune des composantes orthogonales I et Q du signal à amplifier, à partir des rapports d'une part des composantes I des signaux transposés provenant du signal à amplifier et du signal amplifié et d'autre part des composantes Q de ces mêmes signaux transposés et **en ce que** les deux composantes obtenues après pré-distorsion sont combinées pour constituer le signal d'entrée de l'amplificateur (A).

2. Correcteur de linéarité pour amplificateur de puissance, comportant un circuit de modulation (1) pour recevoir un signal modulé à amplifier (E) et le pré-distordre avant amplification par l'amplificateur de puissance (A) et un circuit de mémoire (3) pour commander la modulation effectuée par le circuit de modulation, **caractérisé en ce qu'**il comporte un circuit de détection (2) pour, en fonction de la modulation du signal à amplifier, fournir une adresse du circuit de mémoire, un premier (4) et un second (7) transposeur en bande de base pour recevoir respectivement les signaux à amplifier (E) et amplifié (S), et un processeur (5) pour recevoir l'adresse et pour comparer les signaux fournis par les transposeurs afin de calculer des modifications à apporter éventuellement au contenu du circuit de mémoire.

3. Correcteur de linéarité selon la revendication 2, **caractérisé en ce que** le circuit de mémoire (30) constitue une table à une dimension et **en ce que** le circuit de détection (2) est destiné à fournir l'adresse à partir du module du signal de modulation.

4. Correcteur de linéarité selon la revendication 2, **caractérisé en ce que** le circuit de modulation (1) comporte des moyens de déphasage (10) pour partager le signal à amplifier en deux composantes orthogonales I et Q, un premier et un second multiplieur (11, 12) pour recevoir, sur une première entrée, respectivement les deux composantes et un additionneur de sortie (13) avec deux entrées couplées respectivement aux deux multiplieurs (11, 12) et une sortie couplée à l'amplificateur (A), **en ce que** les transposeurs (40, 41, 42 ; 6, 70, 71) fournissent, en numérique, chacun leur signal sous forme de deux composantes en quadrature I et Q, **en ce que** le circuit de mémoire (30-34) comporte une mémoire (30) à deux cases distinctes par adresse, les deux cases étant respectivement couplées aux secondes entrées des multiplieurs et **en ce que** le processeur est destiné à modifier le contenu des deux cases respectivement à partir de deux rapports dont l'un est relatif aux composantes I fournies par les deux transposeurs et l'autre est relatif aux composantes Q fournies par les deux transposeurs.

5. Correcteur de linéarité selon la revendication 4, **caractérisé en ce que** le premier transposeur (40, 41, 42) comporte un additionneur (40) avec deux entrées connectées aux moyens de déphasage (10) pour recevoir respectivement les deux composantes I et Q du signal à amplifier et **en ce que** le premier transposeur effectue la transposition en bande de base du signal fourni par son additionneur.

6. Amplificateur de puissance, **caractérisé en ce qu'**il est équipé d'un correcteur de linéarité selon l'une au moins des revendications 2 à 5.

## Patentansprüche

1. Verfahren zur Linearitätskorrektur für einen Leistungsverstärker, bei dem eine Vorverzerrung eines zu verstärkenden modulierten Signals (E) aufgrund von gespeicherten Koeffizienten durchgeführt wird, wobei dieses Verfahren darin besteht, die Lieferung der Koeffizienten in Abhängigkeit von der Modulation des zu verstärkenden Signals zu steuern, das zu verstärkende (E) und das verstärkte Signal (S) in das Basisband umzusetzen und ggf. die gespeicherten Koeffizienten in Abhängigkeit von einem Vergleich zwischen den beiden aus der Umsetzung stammenden Signalen zu verändern, **dadurch gekennzeichnet, dass** das zu verstärkende Signal und die in das Basisband umgesetzten Signale je in zwei orthogonale Komponenten I und Q aufgeteilt sind, dass die Vorverzerrung getrennt an jeder der orthogonalen Komponenten I und Q des zu verstärkenden Signals ausgehend von den Verhältnissen einerseits der Komponenten I der umgesetzten Signale, die von dem zu verstärkenden Signal und von dem verstärkten Signal kommen, und andererseits der Komponenten Q dieser gleichen umgesetzten Signale durchgeführt wird, und dass die beiden nach der Vorverzerrung erhaltenen Komponenten kombiniert werden, um das Eingangssignal des Verstärkers (A) zu bilden.

2. Linearitätskorrekturorgan für einen Leistungsverstärker, mit einer Modulationsschaltung (1), die ein zu verstärkendes moduliertes Signal (E) empfangen und es vor der Verstärkung durch den Leistungsverstärker (A) vorverzerren soll, und mit einer Speicherschaltung (3), um die durch die Modulationsschaltung durchgeführte Modulation zu steuern, **dadurch gekennzeichnet, dass** es eine Erfassungsschaltung (2), die in Abhängigkeit von der Modulation des zu verstärkenden Signals eine Adresse der Speicherschaltung liefert, einen ersten (4) und einen zweiten Umsetzer (7) in das Basisband, die das zu verstärkende (E) bzw. das verstärkte Signal (S) empfangen, und einen Prozessor (5) aufweist, der die Adresse empfängt und die von den Umsetzern gelieferten Signale vergleicht, um ggf. am Inhalt der Speicherschaltung durchzuführende Veränderungen zu berechnen.

3. Linearitätskorrekturorgan nach Anspruch 2, **dadurch gekennzeichnet, dass** die Speicherschaltung (30) eine eindimensionale Tabelle bildet, und dass die Erfassungsschaltung (2) dazu bestimmt ist, die Adresse ausgehend vom Modul des Modulationssignals zu liefern.

4. Linearitätskorrekturorgan nach Anspruch 2, **dadurch gekennzeichnet, dass** die Modulationsschaltung (1) Phasenverschiebungsmittel (10), die das zu verstärkende Signal in zwei orthogonale Komponenten I und Q aufteilen, ein erstes und ein zweites Multiplizierorgan (11, 12), die an je einem ersten Eingang eine der beiden Komponenten empfangen, und ein Ausgangsaddierglied (13) mit zwei Eingängen, die mit den beiden Multiplizierorganen (11, 12) gekoppelt sind, und mit einem Ausgang aufweist, der mit dem Verstärker (A) gekoppelt ist, dass jeder Umsetzer (40, 41, 42; 6, 70, 71) sein Signal digital in Form von zwei Komponenten I und Q in Quadratur liefert, dass die Speicherschaltung (30-34) einen Speicher (30) mit zwei verschiedenen Feldern pro Adresse aufweist, wobei die beiden Felder mit den zweiten Eingängen der Multiplizierorgane gekoppelt sind, und dass der Prozessor dazu bestimmt ist, den Inhalt der beiden Felder je ausgehend von zwei Verhältnissen zu verändern, von denen eines sich auf die von den beiden Umsetzern gelieferten Komponenten I und das andere sich auf die von den beiden Umsetzern gelieferten Komponenten Q bezieht.

5. Linearitätskorrekturorgan nach Anspruch 4, **dadurch gekennzeichnet, dass** der erste Umsetzer (40, 41, 42) ein Addierglied (40) mit zwei Eingängen aufweist, die mit den Phasenverschiebungsmitteln (10) verbunden sind, um die beiden Komponenten I bzw. Q des zu verstärkenden Signals zu empfangen, und dass der erste Umsetzer die Umsetzung des von seinem Addierglied gelieferten Signals in das Basisband durchführt.

6. Leistungsverstärker, **dadurch gekennzeichnet, dass** er mit einem Linearitätskorrekturorgan nach mindestens einem der Ansprüche 2 bis 5 ausgestattet ist.

## Claims

1. Method for the correction of linearity for a power amplifier wherein a pre-distortion is performed on a modulated signal to be amplified (E), using stored coefficients, this method consisting in controlling the supply of the coefficients as a function of the modulation of the signal to be amplified, converting into baseband the signal to be amplified (E) and the signal that has been amplified (S) and, if necessary, modifying the coefficients stored as a function of a comparison between the two signals coming from the conversion, **characterized in that** the signal to be amplified and the signals converted into baseband are each divided into two orthogonal components I and Q, **in that** the pre-distortion is performed separately on each of the orthogonal components I and Q of the signal to be amplified, using the ratios between, first, the components I of the converted signals coming from the signal to be amplified and the signal that has been amplified and, secondly, the components Q of these same converted signals, and **in that** the two components obtained after pre-distortion are combined to form the input signal of the amplifier (A).

2. Linearity corrector for a power amplifier comprising a modulation circuit (1) to receive a modulated signal to be amplified (E) and predistort it before amplification by the power amplifier (A) and a memory circuit (3) to control the modulation performed by the modulation circuit, **characterized in that** it comprises a detection circuit (2) to provide, as a function of the modulation of the signal to be amplified, an address of the memory circuit, a first (4) and second (7) converter into baseband to receive respectively the signal to be amplified (E) and the signal that has been amplified (S), and a processor (5) to receive the address and compare the signals given by the converters in order to compute the modifications to be made as the case may be to the contents of the memory circuit.

3. Linearity corrector according to Claim 2, **characterized in that** the memory circuit (30) constitutes a one-dimensional table and **in that** the detection circuit (2) is designed to provide the address from the modulus of the modulation signal.

4. Linearity corrector according to Claim 2, **characterized in that** the modulation circuit (1) comprises phase-shift means (10) to divide the signal to be amplified into two orthogonal components I and Q, a first multiplier (11) and a second multiplier (12) for the reception, at a first input, of the two components respectively and an output adder (13) with two inputs coupled respectively to the two multipliers (11, 12) and one output coupled to the amplifier (A), **in that** the converters (40, 41, 42; 6, 70, 71) each provide, in digital form, their signal in the form of two in-quadrature components I and Q, **in that** the memory circuit (30-34) comprises a memory (30) with two distinct memory slots per address, the two slots being respectively coupled to the second inputs of the multipliers, and **in that** the processor is designed to modify the contents of the two slots respectively on the basis of two ratios, one pertaining to the components I given by the two converters and the other pertaining to the components Q provided by the two converters.

5. Linearity corrector according to Claim 4, **characterized in that** the first converter (40, 41, 42) comprises an adder (40) with two inputs connected to the phase-shift means (10) to receive respectively the two components I and Q of the signal to be amplified and **in that** the first converter performs the conversion into baseband of the signal provided by its adder.

6. Power amplifier, **characterized in that** it is fitted with a linearity corrector according to at least one of Claims 2 to 5.
